# EUROPEAN PATENT APPLICATION

(11) **EP 2 706 130 A2**
(43) Date of publication of application: **12.03.2014**
(21) Application number: 12779850.2
(22) Date of filing: 15.03.2012
(51) Int. Cl.: C23C 16/44, C23C 16/26, C01B 31/02

(54) **METHOD FOR MANUFACTURING HIGH QUALITY GRAPHENE USING CONTINUOUS HEAT TREATMENT CHEMICAL VAPOR DEPOSITION METHOD**

(30) Priority: 03.05.2011 KR 20110041877
(71) Applicant: Korea Advanced Institute Of Science And Technology, Daejeon 305-701 (KR)
(72) Inventor: JEON, Seok-Woo, Daejeon 305-701 (KR); LEE, Jin-Sup, Daejeon 305-701 (KR); OH, Se-Ran, Daejeon 305-701 (KR)
(74) Representative: Kuhnen & Wacker
(86) International application number: PCT/KR2012/001860
(87) International publication number: WO 2012/150763

(57) **Abstract**

Provided is a method of forming graphene having an increased grain size. In the method, a substrate including a catalyst layer formed of a transition metal is loaded into a chamber and a gaseous carbon source is supplied into the chamber. A continuous heat treatment in which the catalyst layer is locally heated while moving a heated area of the catalyst layer is performed to dissolve a carbon component in the catalyst layer and extract graphene on a surface of the catalyst layer from the dissolved carbon component.

## Description

### [Technical Field]

The present invention relates to a method of forming graphene, and more particularly, to a method of forming graphene using improved chemical vapor deposition (CVD) to grow high-quality graphene and increase an average grain size of the graphene.

### [Background Art]

An indium tin oxide (ITO) electrode used as an electrode material for a plastic substrate exhibits many problems when the ITO is actually applied to flexible electronic devices, since a sheet resistance of the ITO increases 1000 times or more when it is bent and the ITO has brittle properties and has a different coefficient of thermal expansion from that of the plastic substrate. Recently, a conductive polymer, a carbon nanotube, a carbon nanofiber, and the like have been considered as conductive materials that may replace the ITO. Among these materials, the carbon nanotube has a high conductivity, can be easily adhered to a substrate, is mechanically and thermally stable, and has thus drawn much attention as a next-generation electrode material.

However, when the carbon nanotube is applied as a single functional element to a device, an input/output current is low, a contact area is small, and a linear carbon nanotube should be synthesized at a desired location. Graphene is a perfect two-dimensional (2D) carbon nano-electronic material that provides a solution to this problem.

The graphene is a planar 2D carbon structure that forms an sp2 bond and is physically and chemically stable. The graphene is capable of carrying electrons 100 times faster than silicon and supplying an amount of current per unit area that is 100 times more than that supplied by copper, at room temperature. Also, the graphene has a thermal conductivity that is twice or more than that of diamond, has a mechanical strength that is 200 times or more stronger than steel, and has transparent properties. Furthermore, the graphene has a hexagonal honeycomb structure in which carbon atoms are connected in a net fashion, is thus flexible due to a spatial margin, and does not lose its electrical conductivity even if it is stretched out or folded. The graphene has the particular structure and physical properties described above, and may thus replace not only the ITO that has been generally used as a main material of a transparent electrode but also silicon that is a main material of a semiconductor.

In order to apply the graphene having the excellent characteristics to flexible electronic devices, a high-quality and spacious single layer of graphene should be produced on a large scale. Also, the graphene should have price competitiveness and secure process stability for commercial use thereof.

Examples of a method of forming graphene include a mechanical method, an epitaxial method, a thermal expansion method, a vapor phase method, a chemical vapor deposition (CVD) method, a graphene oxidation-reduction method, a graphite interlayer compound method, and so on. In general, the CVD method and the graphene oxidation-reduction method are used to form graphene.

In the mechanical method, Scotch tape is adhered to a graphite sample and is then detached from the graphite to obtain graphene in the form of a sheet separated from the graphite on a surface of the Scotch tape. In this case, the number of layers of each of the sheets of graphene is not uniform and the sheets of graphene each have a non-uniform shape, e.g., a shape of torn paper. Furthermore, it is very difficult to obtain spacious sheets of graphene on a large scale.

A method of obtaining graphene by oxidizing, dispersing, and then reducing graphite is one of methods that have been widely used. However, oxygen (O) atoms are not completely removed during the reduction and the obtained graphene has a structural defect.

The epitaxial method is a method of growing a graphene layer on a monocrystalline silicon carbide (SiC) substrate. The thermal expansion method is a method of forming graphene by performing layer separation while removing an oxide by heating a graphite oxide to 1000°C or more. The vapor phase method uses a principle that argon plasma is formed by injecting argon gas and ethanol aerosol into a micro-plasma reactor to cause vaporization and dissolution of ethanol and solid graphene is obtained when the argon plasma is off.

The CVD method is a method of synthesizing graphene using a transition metal that easily adsorbs carbon thereonto at high temperatures as a catalyst layer. The catalyst layer is formed on a substrate and a gas containing carbon is reacted with a mixture gas containing hydrogen at a high temperature, e.g., about 1000°C so that an appropriate amount of carbon may be melted and seeped into or adsorbed onto the catalyst layer. Then, carbon atoms contained in the catalyst layer are cooled to be crystallized on a surface of the catalyst layer, thereby forming a graphene crystalline structure. The synthesized graphene is separated from the substrate by removing the catalyst layer and may be used according to a desired purpose. The number of layers of graphene may be adjusted by controlling the type and thickness of the catalyst layer, a reaction time, a cooling speed, the concentration of a reactive gas, etc.

The CVD method does not need a mechanical or chemical treatment that may cause a defect to occur in graphene, and may cause a spacious layer of graphene to be grown. However, in case of the conventional CVD method, a layer of graphene is grown around the nucleus of carbon and on a random location of a surface of a catalyst layer. A grain boundary is formed when grains of the graphene grown around the nucleus meet each other. The arrangements of these grains are not identical and the grain boundary causes a defect. Also, the grain boundary between these grains is considered as a factor that degrades charge transfer characteristics. The states of defects in the graphene are known as accelerating a reaction between the graphene and an ambient environment.

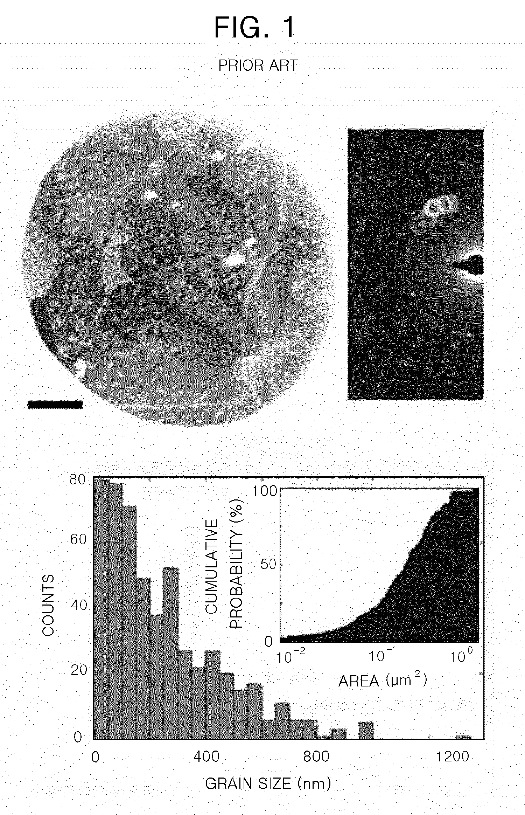

FIG. 1 illustrates pictures contained in an article listed in Nature published in 2011 (pp. 389-392): a transmission electron microscope image of graphene formed by conventional CVD and a histogram of grain sizes of the graphene. Referring to FIG. 1, an average size of the grain is 250 ± 11 nm.

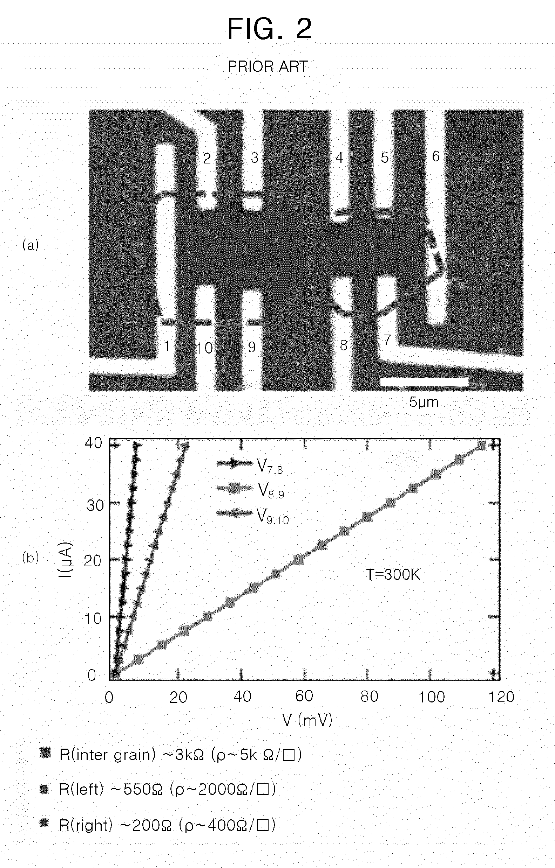

FIG. 2 is a diagram illustrating grains of graphene formed by conventional CVD and electric conductivities at grain boundaries. Specifically, FIG. 2(a) is a picture showing the grains of graphene and the grain boundaries. FIG. 2(b) is a current (I)-voltage (V) graph showing specific resistances of the grains and specific resistances at the grain boundaries that were measured at room temperature. Referring to FIG. 2, a specific resistance increased two to ten times or more at the grain boundaries. This means that the grains act as defects.

### [Detailed Description of the Invention]

### [Technical Problem]

The present invention is directed to a method of forming graphene with an increased grain size.

### [Technical Solution]

According to one aspect of the present invention, a method of forming graphene includes loading a substrate including a catalyst layer formed of a transition metal into a chamber; supplying a gaseous carbon source into the chamber; and performing a continuous heat treatment to locally heat the catalyst layer while moving a heated portion of the catalyst layer so as to dissolve a carbon component into the catalyst layer and extract graphene on a surface of the catalyst layer from the dissolved carbon component.

A speed of moving the heated portion of the catalyst layer may be maintained constant. In some cases, the heated portion of the catalyst layer may be moved and be temporarily stopped to be performed as a stepwise method.

### [Advantageous Effects]

According to the present invention, a grain size of graphene grown from a nucleus may be increased by controlling a nucleation site of graphene by chemical vapor deposition (CVD) using a continuous heat treatment. As the grain size increases, a grain boundary decreases. As heating and cooling have predetermined directivity according to movement of a heat source, the grain boundary is also arranged with predetermined directivity. Thus, the occurrence of a defect due to the grain boundary may be decreased.

That graphene with large grains is obtained means that few defects occur and intrinsic physical properties of graphene may thus be maintained. According to the present invention, as a grain size of graphene increases, a sheet resistance of the graphene may decrease. Thus, the graphene that has been used to form a transparent electrode may be applied to various fields of touchscreens, smart windows, flexible organic light-emitting diodes, solar cells, etc.

### [Brief Description of the Drawings]

FIG. 1 illustrates a transmission electron microscope image of graphene formed by conventional chemical vapor deposition (CVD) and a histogram of grain sizes of the graphene.
FIG. 2 is a diagram illustrating grains of graphene formed by conventional CVD and electric conductivities at grain boundaries.
FIG. 3 is a diagram illustrating operations included in a method of forming graphene by continuous heat treatment CVD according to an embodiment of the present invention.
FIG. 4 illustrates various heat sources to be used in a continuous heat treatment according to embodiments of the present invention.
FIG. 5 is a graph showing a result of performing Raman spectroscopy on graphene formed using a method of forming graphene according to an embodiment of the present invention.
FIG. 6 illustrates a result of performing Raman spectroscopy according to the number of layers of graphene.
FIG. 7 illustrates a result of performing Raman spectroscopy introduced in the supplementary of an article listed in Nature (No. 468, pp. 549-552, published in 2010) according to a comparative example of the present invention.
FIG. 8 illustrates a result of fitting a two-dimensional (2D) peak at a Raman shift of about 2700 cm⁻¹ with respect to graphene formed using a method of forming graphene according to an embodiment of the present invention.

### [Best Mode of the Invention]

According to an exemplary embodiment of the present invention, a continuous heat treatment is performed by disposing a heat wire at a side of a substrate and moving the heat wire or the substrate in a horizontal direction. In this case, a heated area of the heat wire may expand in a lengthwise direction as the heat wire is moved.

According to another exemplary embodiment of the present invention, the continuous heat treatment may be performed using a method of expanding a heat source that is in the form of spring in all directions, starting from the center of the substrate. Otherwise, the continuous heat treatment may be performed using a method of disposing the heat wire on the substrate and rotating the heat wire or the substrate in the horizontal direction. Furthermore, the continuous heat treatment may be performed using a pen or tip type heat source.

### [Mode of the Invention]

Hereinafter, a method of forming graphene by chemical vapor deposition (CVD) using continuous heat treatment according to an exemplary embodiment of the present invention will be described in greater detail with reference to the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those of ordinary skill in the art. The present invention provides an improvement in a conventional CVD method in which grains of graphene are formed on random locations of a surface of a catalyst metal and around the nucleus of carbon. A grain boundary is formed when grains of graphene meet each other. When the arrangements of the grains are not identical to each other, the grain boundary acts as a defect. Accordingly, the present invention is to reduce a defect occurring due to the grain boundary and to increase grain size. To this end, the continuous heat treatment CVD is employed in the present invention.

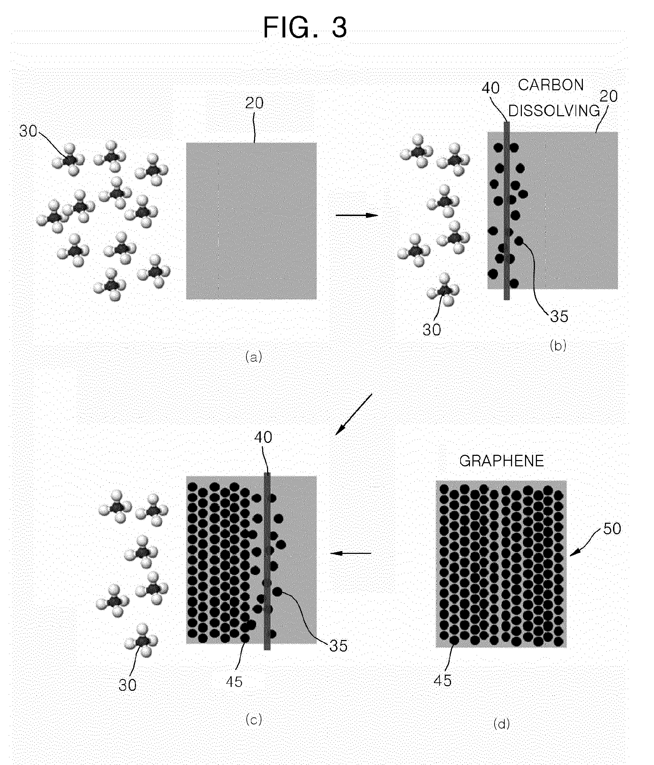

FIG. 3 is a diagram illustrating operations included in a method of forming graphene by continuous heat treatment CVD according to an embodiment of the present invention.

FIG. 3(a) illustrates a state in which a catalyst layer 20 formed of a transition metal is formed on a substrate (not shown) and the substrate is loaded into a chamber. Then, a gas 30 containing carbon, e.g., CH₄ gas, as a gaseous carbon source is preferably mixed with hydrogen (H₂) and a mixture gas is supplied onto the substrate.

Here, a gas supply mechanism is installed in the chamber to supply various gases onto the substrate so as to basically perform CVD. The gas supply mechanism may be embodied as, for example, a shower head that is generally used as a gas supply mechanism of such an apparatus but is not limited thereto. After the substrate on which the catalyst layer 20 is formed is loaded into the chamber, air is exhausted from the chamber using, for example, a pump. Thereafter, a desired process pressure is maintained in the chamber by supplying an appropriate gas into the chamber via the gas supply mechanism while the inside of the chamber is maintained in a vacuum state.

Since the substrate is an auxiliary member for forming graphene, a material of the substrate is not limited but preferably should stand when the substrate is heated to about 1000°C during a subsequent process and be easily removed by an acid treatment to form graphene in a sheet shape separated from the substrate. A doped or undoped silicon substrate on which a silicon oxide film is formed satisfies the above requirements, is not expensive, can be easily obtained, and may thus be used as the substrate.

The catalyst layer 20 helps carbon components to combine each other so as to form a hexagonal tabular structure. As an example, a catalyst used to synthesize graphite, induce a carbonizing reaction, or manufacture a carbon nanotube may be used. More specifically, the catalyst layer 20 may be formed of at least one metal or alloy selected from the group consisting of Ni, Co, Fe, Pt, Au, Al, Cr, Cu, Mg, Mn, Mo, Rh, Si, Ta, Ti, W, U, V, and Zr. The catalyst layer 20 may be formed by dissolving such a metal complex or a metal alkoxide into a solvent such as alcohol, applying a dissolved result on a substrate, and drying the resultant structure. Otherwise, the catalyst layer 20 may be formed on the substrate by metal deposition such as thermal deposition.

Hydrocarbon gases, such as ethane, ethylene, ethanol, acetylene, propane, propylene, butane, butadiene, pentane, and hexane, may be used as the gaseous carbon source. In particular, the gaseous carbon source may contain CH₄ gas, and hydrogen may be further supplied together with the gaseous carbon source.

FIG. 3(b) illustrates a process in which only portions of the catalyst layer 20 near a heat wire 40 placed in the catalyst layer 20 are locally heated to, for example, about 1000°C using the heat wire 40 to react the gas 30 containing carbon with a mixture gas containing hydrogen to cause an appropriate amount of carbon 35 to be dissolved and melted into the portions of the catalyst layer 20 or to be adsorbed onto the portions of the catalyst layer 20. The heat wire 40 acts as a catalyst to accelerate dissolving of the gaseous carbon source when graphene is generated. At the same time, the carbon 35 melted into or adsorbed onto the portions of the catalyst layer 20 near the heat wire 40 at a high temperature is cooled to extract graphene on a surface of the catalyst layer 20 during a subsequent process.

The amount of carbon dissolved in the catalyst layer 20 may be adjusted by controlling a heating temperature and time, the supply rate of the gaseous carbon source, etc. The thickness of a graphene film may increase when the amount of dissolved carbon is increased by increasing the heating time and the supply rate of the gaseous carbon source, and may decrease when the amount of dissolved carbon is decreased by decreasing the heating time and the supply rate of the gaseous carbon source. When the supply rate of the gaseous carbon source is low, a desired amount of carbon may be dissolved by increasing the heating time.

Thereafter, as illustrated in FIG. 3(c), when the location of the heat wire 40 is changed, portions of the catalyst layer 20 by which the heat wire 40 passes are rapidly cooled to extract and crystallize the atoms of the carbon 35 contained in the catalyst layer 20 on the surface of the catalyst layer 20, thereby forming a graphene crystalline structure 45. Then, portions of the catalyst layer 20 near the heat wire 40 in the catalyst layer 20 are locally heated to cause the carbon 35 to be melted into or adsorbed onto the catalyst layer 20, as in the process of FIG. 3(b).

A process of cooling the catalyst layer 20 after the catalyst layer 20 is heated is important to evenly extract graphene so as to obtain high-quality graphene. The thickness of graphene obtained may be less than a desired thickness or cracks may occur in a graphene film when the catalyst layer 20 is fast cooled. The thickness of graphene obtained may be too high or the productivity of graphene may be low when the catalyst layer 20 is slowly cooled. Thus, the catalyst layer 20 is preferably cooled at a controlled regular speed. Ideally, the catalyst layer 20 may be cooled by 1 to 50°C per second. According to the present invention, the ideal cooling speed may be naturally achieved by moving the heat wire 40 at a regular speed.

When the catalyst layer 20 is continuously heated and cooled by continuously changing the location of the heat wire 40 as described above, a graphene sheet 50 having even and large graphene grains may be synthesized on the catalyst layer 20 as illustrated in FIG. 3(d). The graphene sheet 50 may be separated from the substrate by removing the catalyst layer 20 during a subsequent process and may then be used according to a desired purpose. For example, if a substrate on which a silicon oxide film is formed is used, the silicon oxide film and the catalyst layer 20 may be sequentially removed to completely separate the graphene sheet 50 from the substrate when the substrate on which the graphene sheet 50 is also formed is sequentially immersed into an HF solution and a TFG solution, thereby extracting graphene.

As described above, according to the present invention, a carbon component is dissolved in the catalyst layer 20 and the graphene crystalline structure 45 is extracted on a surface of the catalyst layer 20 from the dissolved carbon component by performing the continuous heat treatment in which the catalyst layer 20 is locally heated while moving a heated area of the catalyst layer 20. The speed of moving the heated area of the catalyst layer 20 is preferably maintained constant to form graphene particles having regular sizes on the entire area of the substrate. However, in some cases, the sizes of graphene particles may be controlled by temporarily stopping the continuous heat treatment after the heated area of the catalyst layer 20 is moved.

In the conventional CVD method, the surfaces of a substrate are entirely heated, and a nucleus of graphene is thus formed at a random location and grown in a polycrystalline form. According to the present invention, a substrate is heated using a local heating unit, such as the heat wire 40, to dissolve carbon into a heated area of the substrate so that the carbon may be grown in the form of a nucleus of graphene only on the heated area, without using the conventional CVD method of entirely heating a substrate. The size of graphene are small since a nucleus is formed at a random location when a substrate is heated according to the conventional CVD method, whereas a location at which a nucleus is to be grown may be controlled by locally heating the substrate using the heat wire 40 according to the present invention nucleus. In other words, graphene may be grown around a nucleus of carbon, starting from a predetermined location on a surface of the catalyst layer 20 (a location on the catalyst layer 20 on which a heat source is initially placed).

Thus, a nucleation site is formed on a random location when the conventional CVD method is used, whereas the location of the nucleation site may be controlled by a heat source such as the heat wire 40 according to the present invention, thereby enabling to control the size of graphene. An average size of graphene is 250 ± 11 nm when the conventional CVD method is used, whereas according to the present invention, an average size of graphene is much larger than 250 ± 11 nm.

A grain boundary is formed when grains of graphene grown around the nucleus meet each other. Conventionally, a grain boundary is formed when grains of graphene that are randomly generated meet each other, whereas according to the present invention, arrangements of respective grains of graphene have a predetermined directivity as a heat source is moved having a predetermined directivity. That is, the grains have the directivity according to the movement of the heat wire 40, and a defect caused by the grain boundary is thus reduced. As the grains of graphene are continuously grown according to the movement of the heat wire 40, grain size may be large or single crystalline graphene may be produced on a large scale, compared to the conventional CVD method.

The degree of dissolution of carbon in nickel (Ni) or cobalt (Co) which is a transition metal for the catalyst layer 20 is 1 at.% at 1000°C, and the degree of dissolution of carbon in copper (Cu) which is a transition metal for the catalyst layer 20 is 0.03 at.% at 1000°C. Since the degree of dissolution of carbon in nickel (Ni) and cobalt (Co) is high, atoms of carbon dissolved in the catalyst layer 20 are cooled at room temperature and an excessive amount of carbon is extracted to form a multilayer graphene at 1000°C. Since the degree of dissolution of carbon in copper (Cu) is lower than that in nickel (Ni) and cobalt (Co), a large single layer of graphene may be more easily formed. Nickel (Ni), cobalt (Co), or copper (Cu) may be used as a transition metal for the catalyst layer 20. Otherwise, Fe, Pt, Au, Al, Cr, Mg, Mn, Mo, Rh, Si, Ta, Ti, W, U, V, or Zr may be used as a transtion metal for the catalyst layer 20.

In an experimental embodiment, copper foil was used as a catalyst layer. The copper foil was loaded into a CVD chamber and the CVD chamber was filled with hydrogen (H₂) gas. As illustrated in FIG. 3, the continuous heat treatment was performed in which the substrate was sequentially heated starting from a side thereof while continuously changing the location of the heat wire 40 and was then cooled. The temperature of the heat wire 40 may be adjusted by controlling the amount of current to flow therethrough.

In the experimental embodiment, a heat source was designed by disposing the heat wire 40 at a side of the substrate to be movable horizontally in one direction, and a thermal gradient was formed according to the movement of the heat wire 40. Thus, graphene may be produced from carbon on a location on which the heat wire 40 was placed. Also, graphene may be formed on a desired location using a heat source (including a wire) having a low thermal capacity or a small heating area. Also, since the substrate was rapidly cooled, graphene was not formed on the periphery of the desired location.

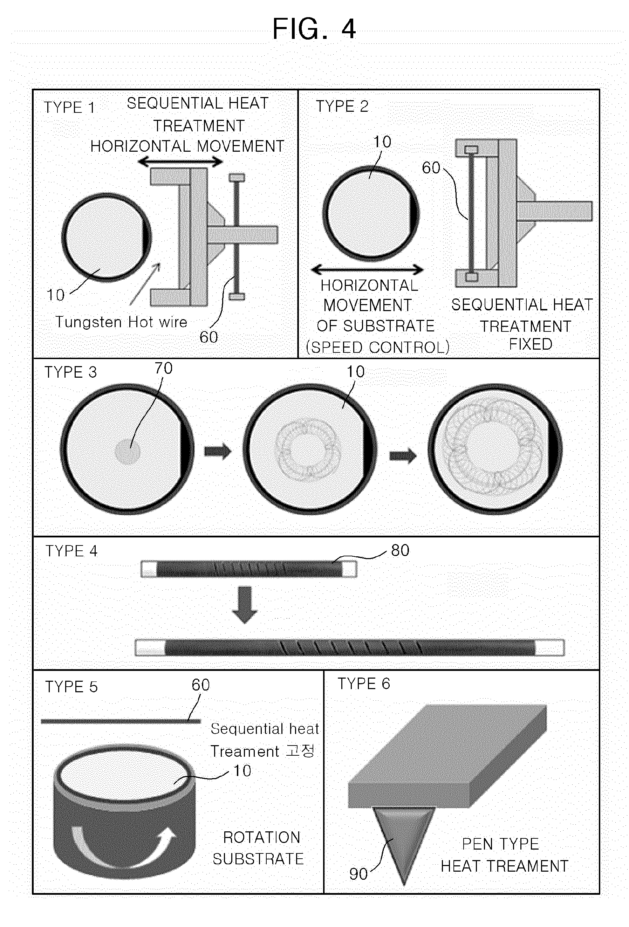

In the experimental embodiment, although the continuous heat treatment was performed while moving the heat wire 40, not only the heat wire 40 but also various materials may be used according to a purpose. Furthermore, the shape of the heat wire 40 is not limited to a linear shape. FIG. 4 illustrates various heat sources that may be used to perform continuous heat treatment CVD according to embodiments of the present invention.

First, in case of Type 1,a heat source 60 is continuously moved in one direction in a state in which a substrate 10 is fixed, and heat may thus be sequentially and continuously supplied to the substrate 10, similar to the experimental embodiment.

In case of Type 2, the continuous heat treatment may be performed by moving a substrate 10 while a heat source 60 is fixed at a predetermined location. Here, the heat source 60 is disposed at a side of the substrate 10 and the substrate 10 is moved horizontally.

In case of Type 3, the continuous heat treatment may be performed on a substrate 10 in a radial direction by expanding a heat source 70 that is in a spring form in various directions from a center of a substrate 10.

Type 4 is an improvement of Type 1,in which a heated area of a heat source 80 increases in a lengthwise direction as the heat source 80 is moved horizontally. That is, the heated area of the heat source 80 gradually increases according to the movement of the heat source 80.

In case of Type 5, a heat source 60 is fixed and a substrate 10 is rotated. For example, a heat wire may be disposed on the substrate 10 and the substrate 10 is rotated horizontally. As a modified example of Type 5, the heat wire may be disposed on the substrate 10 and rotated horizontally to perform the continuous heat treatment.

In case of Type 6, a pen or tip type heat source 90 is used to locally heat a substrate. The heat source 90 heats the substrate almost through a point contact. A heated area of the substrate may be moved by moving the heat source 90 in one direction or moving the heat source 90 on the substrate through a combination of x and y translation movements or in a zigzag fashion.

The present invention includes all ranges of continuous heat treatments or local heat treatments performed using not only the various heat sources illustrated in FIG. 4 but also through a continuous movement of a heat source or substrate. Table 1 shows types of heat sources classified according to usage and process temperature.

**[Table 1]**

| Classification | Type | Process temperature |
|---|---|---|
| Metal | Ni - Cr system | 100 to 1400°C |
| | Fe - Cr - Al system | |
| | high melting point metal (Pt, Mo, W, Ta, etc.) | |
| Non-metal | silicon carbide | 700 to 1550°C |
| | super kanthal | 1000 to 1900°C |
| | graphite | 1000 to 2200°C |

According to the present invention, the speed of moving a heat wire may be adjusted, for example, to several tens of nanometers per minute (nm/min) to several kilometers per minute (km/min). The movement of the heat wire may be understood as an index representing how fast a point on the substrate can be heated and cooled.

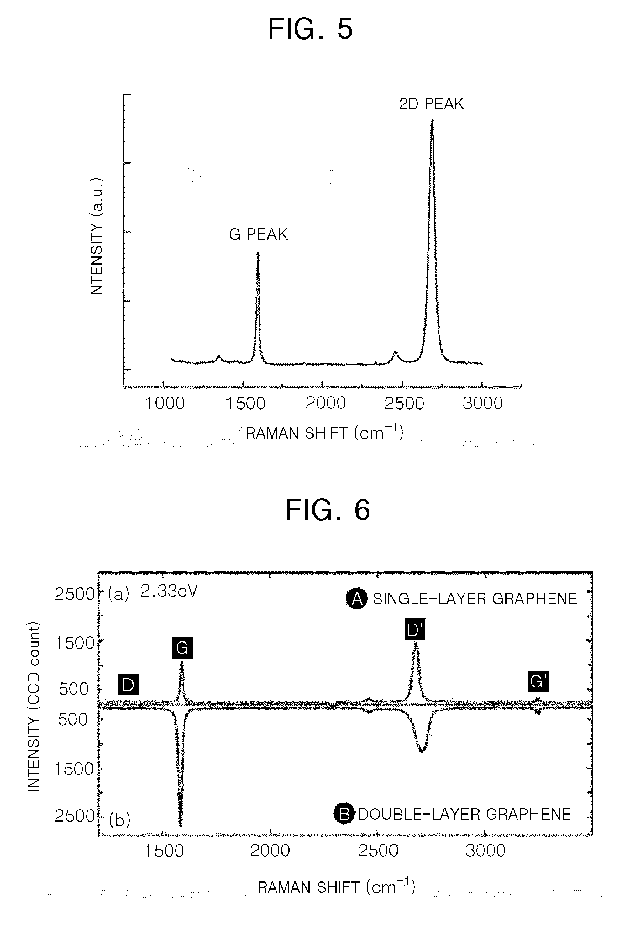

FIG. 5 is a graph showing a result of performing Raman spectroscopy on graphene formed using a method of forming graphene according to an embodiment of the present invention.

In an experimental example, a tungsten heat wire having a diameter of 1 mm and a length of 150 mm was used as a heat source. The speed of moving the heat source was set to 0.3 mm/min. An area of a substrate was heated by the heat source to 1000°C at which carbon can be dissolved. A thermal gradient was set such that a temperature difference was 50 to 70°C when the heat source is moved by 1 mm.

As illustrated in FIG. 5, the result of performing Raman spectroscopy on graphene formed according to the present invention revealed that a G-peak was formed at a Raman shift of about 1580 cm⁻¹ and a 2D peak was formed at a Raman shift of about 2700 cm⁻¹. A result of performing the continuous heat treatment using equipment revealed that high-quality graphene was actually grown.

A result of performing Raman spectroscopy according to the number of layers of graphene is illustrated in FIG. 6. FIG. 6 illustrates a result of performing Raman spectroscopy that is contained in an article listed in Nano Lett. (published in 2007, pp. 238-242) and that compares Raman spectrums of single-layer graphene and double-layer graphene. When FIGS. 5 and 6 are compared with each other, graphene formed according to the present invention was analyzed to be in the form of a single layer. Accordingly, the quality of single-layer graphene formed according to the present invention is very high.

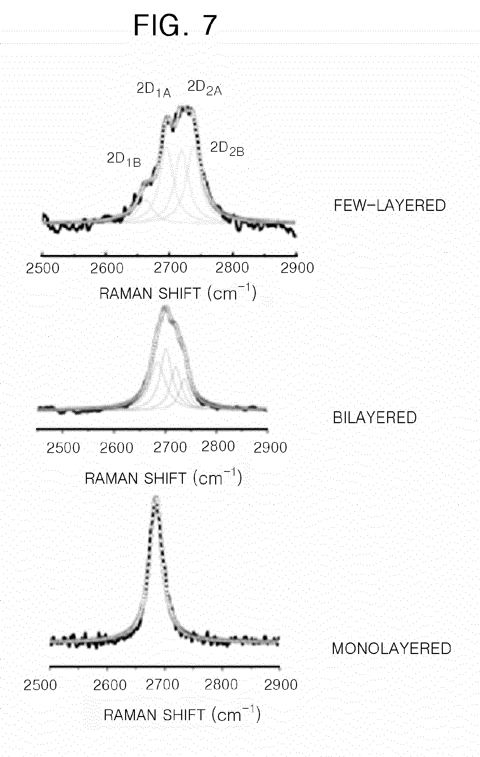

FIG. 7 illustrates a result of performing Raman spectroscopy introduced in the supplementary of an article listed in Nature (No. 468, pp. 549-552, published in 2010) according to a comparative example of the present invention. Referring to FIG. 7, a 2D peak may be fitted as one Lorentz peak at a Raman shift of about 2700 cm⁻¹ in case of single-layer graphene but may be divided into four Lorentz peaks in case of double-layer graphene.

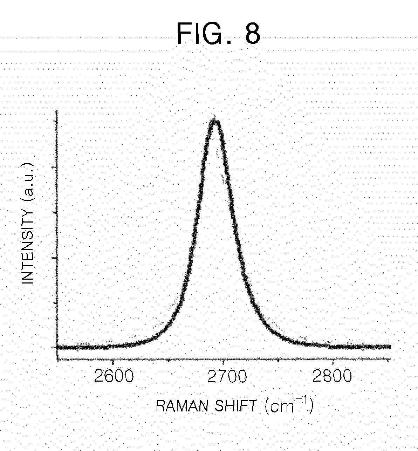

FIG. 8 illustrates a result of performing Raman spectroscopy on graphene formed according to the present invention, in which one Lorentz peak was obtained as a result of fitting a 2D peak at a Raman shift of about 2700 cm⁻¹ with respect to graphene formed using a method of forming graphene according to an embodiment of the present invention. In FIG. 8, a spectrum indicated by a solid line denotes the result of performing Raman spectroscopy and a spectrum indicated by a dotted line denotes the result of fitting the 2D peak. Thus, it revealed that single-layer graphene was grown according to the present invention.

While the present invention has been particularly shown and described with reference to exemplary embodiments thereof, the present invention is not limited thereto and it will be understood by those of ordinary skill in the art that various changes in form and details may be made therein without departing from the spirit and scope of the invention as defined by the appended claims. These exemplary embodiments of the present invention are considered in all exemplary and nonrestrictive viewpoints, and are to cover all modifications, equivalents, and alternatives falling within the scope of the invention defined in the appended claims rather than the specification.

## Claims

1. A method of forming graphene, comprising:
loading a substrate including a catalyst layer formed of a transition metal into a chamber;
supplying a gaseous carbon source into the chamber; and
performing a continuous heat treatment to locally heat the catalyst layer while moving a heated portion of the catalyst layer so as to dissolve a carbon component into the catalyst layer and extract graphene on a surface of the catalyst layer from the dissolved carbon component.

2. The method of claim 1, wherein a speed of moving the heated portion of the catalyst layer is maintained constant.

3. The method of claim 1, wherein the continuous heat treatment is performed by disposing a heat wire at a side of the substrate and moving the heat wire or the substrate horizontally.

4. The method of claim 3, wherein the heated portion of the heat wire expands in a lengthwise direction as the heat wire is moved.

5. The method of claim 1, wherein the continuous heat treatment is performed by expanding a heat source that is in the form of a spring in various directions from a center of the substrate.

6. The method of claim 1, wherein the continuous heat treatment is performed by disposing a heat wire on the substrate and rotating the heat wire or the substrate horizontally.

7. The method of claim 1, wherein the continuous heat treatment is performed using a pen or tip type heat source.

8. The method of claim 1, wherein the catalyst layer is formed of nickel (Ni), cobalt (Co), or copper (Cu).
